# EUROPÄISCHE PATENTSCHRIFT

(11) **EP 1 015 667 B1**
(45) Veröffentlichungstag und Bekanntmachung des Hinweises auf die Patenterteilung: **20.03.2002**
(21) Anmeldenummer: 98949944.7
(22) Anmeldetag: 19.08.1998
(51) Int. Cl.: C25D 1/00

(54) **VERFAHREN UND VORRICHTUNG ZUR KONZENTRATIONSREGULIERUNG VON STOFFEN IN ELEKTROLYTEN**
METHOD AND DEVICE FOR REGULATING THE CONCENTRATION OF SUBSTANCES IN ELECTROLYTES
PROCEDE ET DISPOSITIF POUR REGULER LA CONCENTRATION DE SUBSTANCES DANS DES ELECTROLYTES

(30) Priorität: 21.08.1997 DE 19736350
(43) Veröffentlichungstag der Anmeldung: 05.07.2000
(73) Patentinhaber: ATOTECH Deutschland GmbH, 10553 Berlin (DE)
(72) Erfinder: GEISLER, Jens-Eric, D-10629 Berlin (DE); WÄCHTER, Ralf-Peter, D-90518 Altdorf (DE); KOPP, Lorenz, D-90518 Altdorf (DE); MAURER, Manfred, D-91180 Heideck (DE)
(74) Vertreter: Effert, Bressel und Kollegen
(86) Internationale Anmeldenummer: DE9802505
(87) Internationale Veröffentlichungsnummer: WO9910564

(56) Entgegenhaltungen:
- DE-A- 4 344 387

## Beschreibung

Die Erfindung betrifft ein Verfahren und eine Vorrichtung zur Regulierung der Konzentration von Stoffen in Elektrolyten zur Abscheidung von Metall. Vorzugsweise findet das Verfahren Anwendung bei der Galvanisierung von Leiterplatten in Tauchbadanlagen und in horizontalen oder vertikalen Durchlaufanlagen jeweils unter Verwendung von unlöslichen Anoden.

Beim Galvanisieren unter Verwendung von unlöslichen Anoden muß dafür gesorgt werden, daß die Metallionenkonzentration des abzuscheidenden Metalls im Elektrolyten aufrechterhalten und möglichst konstant bleibt. Dies kann zum Beispiel dadurch erreicht werden, daß der Elektrolyt mit metallhaltigen Salzen ergänzt wird. Die hierfür aufzuwendenden Versorgungs- und Entsorgungskosten sind sehr groß. Eine weitere bekannte Methode zur Ergänzung von Metallionen im Elektrolyten ist die direkte Auflösung des Metalls im Elektrolyten mittels eines Oxidationsmittels wie Sauerstoff. Zur Kupfergalvanisierung wird zum Beispiel metallisches Kupfer von einem Elektrolyten, der mit Luftsauerstoff angereichert ist, aufgelöst. Rückstände, wie sie bei der Ergänzung mit Metallsalzen auftreten, gibt es dabei nicht. Allerdings entsteht beim Galvanisieren in beiden Fällen Sauerstoff an den unlöslichen Anoden der elektrolytischen Zelle. Dieser Sauerstoff greift die organischen Additive des Elektrolyten an. Zusätzlich bewirkt er eine korrosive Zerstörung des Anodenwerkstoffes.

Verfahren zur elektrolytischen Metallabscheidung, bei denen die vorgenannten Probleme gelöst wurden und die Metallionenkonzentration im Elektrolyten ohne Gasbildung an den unlöslichen Anoden konstant gehalten werden kann, sind in DD 215 589 A1 und DE 43 44 387 A1 beschrieben. Dem Elektrolyten werden danach Verbindungen eines geeigneten Redoxsystems zugegeben, die elektrochemisch in die oxidierte bzw. die reduzierte Form überführt werden können. Beim Galvanisieren werden die Verbindungen an den unlöslichen Anoden in der elektrolytischen Zelle unter Vermeidung einer Gasbildung oxidiert. Bei der Reduktion der Verbindungen in der oxidierten Form außerhalb der elektrolytischen Zelle wird das in einem Behälter befindliche elektrolytisch abzuscheidende Metall außenstromlos aufgelöst. Der so mit Metallionen angereicherte Elektrolyt wird im Kreislauf durch die elektrolytische Zelle und durch den genannten Behälter geführt. Somit findet ein ständiger Transport von oxidierten lonen des Redoxmittels aus der elektrolytischen Zelle in den Behälter und ein Transport von reduzierten lonen des Redoxmittels wieder in die elektrolytische Zelle zurück statt. Weil in dem Behälter das abzuscheidende Metall in Form von lonen in Lösung geht, wird der Behälter nachfolgend lonengenerator genannt.

Für die elektrolytische Verkupferung von Leiterplatten aus einer mit einem Eisenzusatz als Redoxmittel versehenen Elektrolytflüssigkeit liegen umfangreiche Erfahrungen vor. Es zeigt sich, daß insbesondere bei den praktisch anzuwendenden Stromdichten in der elektrolytischen Zelle der idealfall der vollständigen Oxidation des Redoxmittels an den unlöslichen Anoden nicht erreicht werden kann. Desgleichen werden die oxidierten lonen des Redoxmittels nicht nur im lonengenerator, sondern zu einem geringen Anteil auch an der Kathode in der elektrolytischen Zelle parasitär reduziert. Die Folge davon ist, daß die kathodische Stromausbeute sinkt und daher nur bei etwa 90 Prozent liegt.

In die Elektrolytflüssigkeit wird durch Elektrolytbewegungen ständig Luft eingetragen, so daß sich in der Luft enthaltener Sauerstoff in der Flüssigkeit löst. Dieser ist in der Lage, Kupfer aufzulösen. Im lonengenerator wird somit das dort befindliche Metall zum einen durch Reduktion der oxidierten Form des Redoxmittels und zum anderen zusätzlich durch gelösten Sauerstoff aufgelöst. Ein Gleichgewicht zwischen der Bildung von Metallionen in der Lösung durch Metallauflösung und Verbrauch der Metallionen durch elektrolytische Metallabscheidung stellt sich daher nicht ein. Der Gehalt der abzuscheidenden Metallionen in der Elektrolytflüssigkeit nimmt vielmehr kontinuierlich zu.

Der Metallionengehalt in der Lösung muß jedoch in engen Grenzen gehalten werden, um ausreichend gute physikalische Eigenschaften des abgeschiedenen Metalls zu gewährleisten. Bei dem beschriebenen Verfahren mit unlöslichen Anoden und unter Verwendung von Verbindungen eines Redoxsystems ist es nicht möglich, die Konzentration der Metallionen in der Elektrolytflüssigkeit durch Metallabscheidung in einer zusätzlichen elektrolytischen Nebenzelle unter Verwendung einer unlöslichen Anode abzusenken, so wie es von herkömmlichen Galvanisieranlagen mit löslichen Anoden bekannt ist.

Bei Galvaniseranlagen, die mit unlöslichen Anoden und unter Verwendung eines Redoxsystems arbeiten, muß auch die elektrolytische Nebenzelle mit einer unlöslichen Anode ausgerüstet sein. Beim Galvanisieren wird in dieser Nebenzelle Metall aus dem Elektrolyten zwar herausgearbeitet. Zugleich wird das Redoxmittel aber an der Anode der Nebenzelle oxidiert. Der Gehalt der oxidierten lonen des Redoxmittels steigt im Elektrolyten daher entsprechend an. Elektrolyt mit dem sich daraufhin einstellenden erhöhten Gehalt an Metallionen gelangt mit dem Elektrolytstrom in den lonengenerator. Dort wird entsprechend mehr Metall elektrochemisch durch Reduktion des Redoxmittels aufgelöst.

Zur Absenkung des Metallgehaltes in der Lösung beziehungsweise dessen Konstanthaltung besteht daher mit den bekannten Methoden nur die Möglichkeit einer permanenten Verdünnung der Elektrolytlösung. Hierzu müssen ständig große Elektrolytmengen verworfen und entsorgt werden. Bei einer sechs Meter langen Durchlaufgalvanisieranlage sind dies im Drei-Schichtbetrieb wöchentlich ca. 500 Liter Elektrolyt. Zusätzlich müssen auch die verworfenen organischen und anorganischen Additive des Elektrolyten ergänzt werden. Unter ökonomischen und ökologischen Gesichtspunkten ist dieses Verfahren, das als "feed and bleed"-Verfahren bekannt ist, unbefriedigend.

Voraussetzung für den Dauerbetrieb einer Galvanisieranlage mit unlöslichen Anoden und unter Verwendung eines Redoxsystems in der Elektrolytflüssigkeit ist, daß sich ein Gleichgewicht zwischen der Auflösung des abzuscheidenden Metalls und dessen Abscheidung auf dem Behandlungsgut einstellt.

In bekannten Galvanisieranlagen wird der Elektrolyt mit Hilfe von Pumpen an das Behandlungsgut gefördert. Durch die beim Fördern entstehenden Strömungsbewegungen in der Elektrolytflüssigkeit, insbesondere auch im Rücklauf des Elektrolyten zum Galvanisierbehälter über Fallstrecken wird Luft in den Elektrolyten eingetragen. In Tauchanlagen zum Galvanisieren wird zur Elektrolytumwälzung vorzugsweise eine Lufteinblasung eingesetzt. In allen diesen Fällen gelangt Luftsauerstoff in den Elektrolyten. Eine Vermeidung dieses Sauerstoffeintrages ist nur mit einem sehr großen anlagentechnischen Aufwand realisierbar. Eine Möglichkeit zur Lösung dieses Problems könnte beispielsweise darin bestehen, die gesamte Elektrolytflüssigkeit mit einem Inertgas abzudecken. Hierzu müßte aber die gesamte Galvanisieranlage einschließlich des lonengenerators mit großem technischem Aufwand gasdicht gekapselt werden.

Der Erfindung liegt von daher das Problem zugrunde, die Nachteile der bekannten Verfahren und Vorrichtungen zu vermeiden und insbesondere ein wirtschaftliches Verfahren und eine Vorrichtung anzugeben, die geeignet sind, bei der elektrolytischen Metallabscheidung in elektrolytischen Zellen, die unlösliche Anoden aufweisen und in denen ein Abscheideelektrolyt eingesetzt wird, der Verbindungen eines reversiblen Redoxsystems enthält, den Gehalt an lonen des Metalls konstant zu halten, das elektrolytisch auf dem Behandlungsgut abgeschieden werden soll.

Das Problem wird gelöst durch das Verfahren gemäß Patentanspruch 1 und die Vorrichtung nach Patentanspruch 9.

Bei dem erfindungsgemäßen Metallabscheideverfahren wird das Metall aus der Elektrolytflüssigkeit unter Verwendung von unlöslichen Anoden auf Behandlungsgut abgeschieden. In der Elektrolytflüssigkeit sind zusätzliche Verbindungen eines elektrochemisch reversiblen Redoxsystems enthalten. Mit der oxidierten Form dieser Redoxverbindungen wird Metall in einem von der Elektrolytflüssigkeit durchströmten lonengenerator aufgelöst, wobei diese Verbindungen reduziert werden. Die reduzierte Form der Verbindungen des Redoxsystems wird an unlöslichen Anoden wieder oxidiert. Zur Regulierung der Konzentration der Metallionen in der Elektrolytflüssigkeit wird erfindungsgemäß
a. zumindest ein Teil der in der Galvanisieranlage enthaltenen Elektrolytflüssigkeit durch eine oder mehrere mindestens eine weitere unlösliche Anode und mindestens eine Kathode aufweisende elektrolytische Hilfszellen geleitet und
b. zwischen den Anoden und den Kathoden der Hilfszellen ein so hoher elektrischer Stromfluß eingestellt, daß die Stromdichte an der Anodenoberfläche mindestens 6 A/dm², vorzugsweise mindestens 12 A/dm² und besonders bevorzugt mindestens 20 A/dm², und die Stromdichte an der Kathodenoberfläche höchstens 3 A/dm², vorzugsweise höchstens 0,5 A/dm² und besonders bevorzugt höchstens 0,2 A/dm², beträgt.

Die erfindungsgemäße Vorrichtung weist eine Galvanisieranlage mit mindestens einem Galvanisierbehälter, unlöslichen Anoden und einer Stromversorgung für die Metallabscheidung auf dem Behandlungsgut auf, die mit den Anoden und dem Behandlungsgut elektrisch verbunden ist, und ferner
a. mindestens eine elektrolytische Hilfszelle, jeweils bestehend aus
   i. mindestens einer Kathode,
   ii. mindestens einer unlöslichen Anode,
   iii. wobei das Verhältnis der Oberfläche der Anode zur Oberfläche der Kathode mindestens 1 : 4, vorzugsweise 1 : 6 oder mehr und besonders bevorzugt 1 : 10 oder auch mehr, beträgt, sowie
   iv. einer Stromversorgung für die Hilfszellen, die mit den Anoden und den Kathoden der Hilfszellen elektrisch verbunden ist, und
b. Mittel, mit denen ein Flüssigkeitskreislauf der Elektrolytflüssigkeit zwischen den Hilfszellen und der Galvanisieranlage erzeugbar ist, beispielsweise Flüssigkeitsleitungen und Pumpen.

Durch die Erfindung wird ein großer technischer Aufwand zur Konstanthaltung der Metallionenkonzentration vermieden, indem zumindest ein Teil der Verbindungen des Redoxsystems in der oxidierten Form in mindestens einer elektrolytischen Hilfszelle, durch die die Elektrolytflüssigkeit der Galvanisieranlage geleitet wird, zur reduzierten Form elektrolytisch reduziert wird. Diese Verbindungen werden dabei nicht außenstromlos reduziert, indem gleichzeitig abzuscheidendes Metall aufgelöst wird. Der Teil der Verbindungen des Redoxsystems in der oxidierten Stufe, der in den Hilfszellen reduziert wird, steht im lonengenerator zur außenstromlosen Metallauflösung nicht mehr zur Verfügung. Dadurch wird ein geringerer Anteil abzuscheidender Metallionen durch die Redoxverbindungen oxidiert.

Durch Einstellen des Stromflusses in den Hilfszellen wird die Produktionsrate der Verbindungen in der reduzierten Form und damit nachfolgend die Produktionsrate der Metallionen im lonengenerator auf einen Wert eingestellt, der so groß ist, daß die pro Zeiteinheit erzeugte Menge an Metallionen durch Oxidation mit den Redoxverbindungen zuzüglich der Menge, die durch Auflösung des Metalls durch den in den Elektrolyten eingetragenen Luftsauerstoff entsteht, genau gleich der Menge der an der Kathode in der Galvanisieranlage verbrauchten Metallionen ist. Somit bleibt der Gesamtionengehalt des abzuscheidenden Metalls im Elektrolyten der Galvanisieranlage konstant. Bei Anwendung des erfindungemäßen Verfahrens stellt sich also das gewünschte Gleichgewicht zwischen Metallionenbildung und deren Verbrauch ein.

Würden die Hilfszellen mit Anoden- und Kathodenpotentialen betrieben, wie sie in der Galvanisieranlage vorliegen, so würde an der Kathode der Hilfszelle ebenso wie in der Galvanisieranlage Metall abgeschieden werden. An den Anoden der Hilfszellen werden die Verbindungen des Redoxsystems oxidiert. Eine Stabilisierung des Metallionengehaltes im Gesamtsystem wäre in diesem Falle nicht erreichbar. Dagegen wird in den elektrolytischen Hilfszellen erfindungsgemäß eine ungewöhnlich hohe anodische Stromdichte und zugleich eine ungewöhnlich niedrige kathodische Stromdichte eingestellt, so daß eine Stabilisierung des Metallionengehaltes mit hohem Wirkungsgrad erreicht wird. An der Kathode wird in diesem Fall überraschenderweise sehr wenig oder kein Metall abgeschieden. Wegen des sich dann einstellenden niedrigen Kathodenpotentials werden statt dessen überwiegend die Verbindungen in der oxidierten Stufe des Redoxsystems an der Kathode reduziert. An der Anode entsteht in einer elektrochemischen Gegenreaktion wegen des hohen Anodenpotentials Sauerstoff. An der Kathode werden die Verbindungen in der oxidierten Stufe des Redoxsystems durch den Hilfszellenstrom reduziert. Gleichzeitig wird ein Teil des Metalls abgeschieden. Beides führt letztendlich zu einer Verringerung der lonenkonzentration des abzuscheidenden Metalls im Elektrolyten. In einer Gegenreaktion wird an den Anoden der Hilfszellen nur noch ein kleiner Teil der Verbindungen des Redoxsystems oxidiert. Überwiegend wird Sauerstoff gebildet, weil wegen der hohen Stromdichte ein hohes Anodenpotential anliegt.

Die sich an den Elektroden der Hilfszellen einstellenden Potentiale bestimmen die elektrolytischen Vorgänge in der Zelle. Durch Festlegung des Verhältnisses der Oberfläche der Anoden zur Oberfläche der Kathoden der Hilfszellen wird auch das Stromdichteverhältnis an diesen Elektroden festgelegt. Dadurch können die erfindungsgemäßen Stromdichtewerte erreicht werden.

Bei niedrigem Kathodenpotential, das bei einer kleinen kathodischen Stromdichte, wie zum Beispiel bei 0,1 A/dm² bis 0,5 A/dm² vorliegt, wird wenig Metall auf den Kathoden der Hilfszellen abgeschieden. In diesem Fall werden überwiegend die Verbindungen in der oxidierten Stufe des Redoxsystems reduziert. Da wenig Metall auf den Kathoden der Hilfszellen abgeschieden wird, muß nachfolgend wenig Metall von diesen Kathoden wieder abgelöst werden, um diese wieder in den ursprünglichen Zustand zu versetzen. Daher kann unter diesen Bedingungen eine kurze Entmetallisierungszeit gewählt werden. Der Wirkungsgrad der Hilfszellen ist dann auch groß, da parasitäre Ströme, beispielsweise eine Abscheidung von Metall, nur einen kleinen Anteil des gesamten kathodischen Stromes beiträgt. Mit zunehmender kathodischer Stromdichte nimmt die Kupferabscheidung an den Kathoden der Hilfszellen dagegen zu und die elektrolytische Reduktion der Verbindungen in der oxidierten Stufe des Redoxsystems ab. Grundsätzlich eignen sich auch höhere kathodische Stromdichten, wie zum Beispiel 3 A/dm² oder 10 A/dm², und ein sich daraufhin einstellendes höheres Potential an den Kathoden, zur Verringerung des Metallgehaltes im Elektrolyten. Bei Einstellung dieser Stromdichten nimmt jedoch der Wirkungsgrad der Hilfszelle ab, das heißt die aufzuwendende elektrische Energie zur Reduktion der Verbindungen des Redoxsystems in der oxidierten Form steigt an, da der Anteil der Metallabscheidung zunimmt. Unter diesen Bedingungen wird auch der Aufwand zur Entmetallisierung beziehungsweise zur Wartung der Kathoden größer.

Auch an den Anoden der Hilfszellen wird der Wirkungsgrad der Hilfszellen mit dem Potential beeinflußt. Bei einem hohen Anodenpotential bei hoher anodischer Stromdichte, wie zum Beispiel 20 A/dm² oder 60 A/dm², wird praktisch nur noch Sauerstoff an der Anode produziert. Mit abnehmendem Potential, das heißt mit abnehmender anodischer Stromdichte, wie zum Beispiel 6 A/dm², werden auch die Verbindungen in der reduzierten Stufe des Redoxsystems oxidiert. Die Konzentration dieser Verbindungen im Elektrolyten steigt dann an und damit auch die Geschwindigkeit der Metallauflösung. Auch dies stellt eine Verringerung des Wirkungsgrades der Hilfszellen dar.

Um einen hohen Wirkungsgrad der Hilfszellen zu erzielen und längere unproduktive Wartungszeiten zu vermeiden, wird in der Praxis eine hohe anodische Stromdichte und eine niedrige kathodische Stromdichte eingestellt. Zur Einstellung der erforderlichen unterschiedlichen Stromdichten in der Hilfszelle wird die Oberfläche der Anoden der Hilfszellen im Verhältnis zu Oberfläche der Kathoden sehr groß gewählt. Das Flächenverhältnis sollte mindestens 1 : 4, vorzugsweise mindestens 1 : 6 oder besser noch mindestens 1:10, betragen. Besonders bevorzugt sind Verhältnisse von mindestens 1 : 40 und insbesondere von mindestens 1 : 100. Erreicht wird dies in der Praxis durch stabförmige Anoden, die in rohrförmige Kathoden eintauchen. Zur Vergrößerung der wirksamen Oberfläche können die Kathoden aus rohrförmigem Streckmetall bestehen, das zugleich infolge des Gitterstruktur einen sehr guten Elektrolytaustausch ermöglicht. Geeignet ist hierfür der Werkstoff Titan, der beim elektrolytischen Entmetallisieren anodisch passiviert wird und sich daher nicht auflöst.

Die Anoden, die vorzugsweise auch aus Titan bestehen, werden an der Oberfläche mit einem Überzug aus Edelmetall und/oder einem Metallmischoxid versehen, um die Polarisationsüberspannung zu vermindern und die Anoden elektrisch leitfähig zu halten und ferner um die Anoden zugleich gegen einen elektrolytischen Abtrag zu schützen. Die Hilfszelle oder die Hilfszellen werden von mindestens einer Gleichstromquelle gespeist. Umpoleinrichtungen, beispielsweise elektrische Schalter und/oder Umpolschalter, die zum Beispiel zeitgesteuert betrieben werden, dienen zur Umpolung des Stromflusses zwischen den Anoden und den Kathoden der Hilfszellen und erlauben damit den zeitweiligen anodischen Betrieb der rohrförmigen Kathoden. Hierzu werden diese Einrichtungen in den elektrischen Verbindungsleitungen zwischen der Stromversorgung für die Hilfszellen und den Hilfszellen vorgesehen. Durch zeitweilige Umpolung des Stromflusses zwischen den Anoden und den Kathoden der Hilfszellen wird die geringfügige Metallisierung der Hilfszellenkathode bedarfsweise von Zeit zu Zeit entmetallisiert.

In einer anderen Betriebsart werden die Hilfszellen in elektrisch separat geschaltete Gruppen aufgeteilt und gruppenweise verkabelt, so daß der Stromfluß zwischen den Anoden und den Kathoden in den einzelnen Gruppen nacheinander umgepolt werden kann. In einer Gruppe oder einigen Gruppen wird in diesem Fall an den rohrförmigen Kathoden Metall abgeschieden, während im anderen Teil der Hilfszellen zeitgleich unter Stromanwendung die Verbindungen in der oxidierten Stufe des Redoxmittels reduziert werden. Nacheinander werden alle Gruppen kathodisch und anodisch betrieben.

Metall kann von den Kathoden auch wieder entfernt werden, indem die Kathoden der Hilfszellen in der Elektrolytflüssigkeit stromlos entmetallisiert werden. In diesem Fall werden einzelne Gruppen von Hilfszellen oder alle Hilfszellen stromlos geschaltet. Die auf den Kathoden befindlichen Metallniederschläge werden dann stromlos wieder abgeätzt. Dies entspricht dem Vorgang im lonengenerator. Die Entmetallisierung an der Kathode findet zum Zweck der Reinigung statt, die von Zeit zu Zeit weitere Wartungsarbeiten zur Folge hat.

An den Anoden der Hilfszellen entstehendes Gas, vorzugsweise Sauerstoff, kann mittels Diaphragmen, die um die Anoden gelegt werden und sich dadurch zwischen den Anoden und den Kathoden befinden, vom durchfließenden Elektrolyt getrennt und durch eine obere Öffnung abgeleitet werden, wenn die Diaphragmen nach oben hin offen sind. Die Diaphragmen bestehen zum Beispiel aus einem nach oben offenen Sack aus Gewebe, vorzugsweise Polypropylengewebe.

Die elektrolytischen Hilfszellen müssen vom Elektrolyten der Galvanisieranlage durchströmt werden. Die Reduktion des Redoxmittels wird insbesondere durch eine starke Strömung an den Kathoden der Hilfszellen erhöht. Dies entspricht einer Steigerung des Wirkungsgrades der Hilfszellen. In einer einfachen Ausführungsform werden die Hilfszellen in den Elektrolytstrom innerhalb der Galvanisieranlage plaziert. Dadurch können zusätzliche Behälter, Rohrleitungen und Pumpen entfallen. Nachteilig ist der Platzbedarf der Hilfszellen in der Anlage sowie der Aufwand für die sichere Gasableitung von den Anoden. Diese Nachteile werden dadurch vermieden, daß die Hilfszellen in von den Galvanisierbehältern der Galvanoanlage getrennten Behältern angeordnet sind und die Elektrolytflüssigkeit die Galvanisierbehälter und die Hilfszellen im Kreislauf durchströmen. Die Hilfszellen können in Kombination mit dem lonengenerator und/oder mit Elektrolytfiltereinrichtungen der Galvanisieranlage in einem Behälter gemeinsam aufgebaut sein. Ferner sind in diesem Fall Einrichtungen zur Förderung der Elektrolytflüssigkeit aus dem Galvanisierbehälter durch diese gemeinsame Anordnung, beispielsweise Rohrleitungen und Pumpen, vorgesehen.

Zur Vermeidung einer zu hohen Metallkonzentration in der Elektrolytflüssigkeit ist in den Hilfszellen im Dauerbetrieb in einer sechs Meter langen Galvanisieranlage ein dauernd fließender Strom von ca. 200 Ampere erforderlich. Der Wirkungsgrad liegt dann bei 80 Prozent. Bei einer kathodischen Stromdichte in Höhe von 0,5 A/dm² entspricht dies einer Kathodenfläche von 400 dm². Die anodische Stromdichte in Höhe von 20 A/dm² erfordert eine Anodenoberfläche von 10 dm². Zweckmäßigerweise werden diese Flächen aufgeteilt und in mehreren Hilfszellen untergebracht. Für die erwähnte Anlage sind zwölf Hilfszellen mit 10 mm dicken und 400 mm langen Anodenstäben eine praktikable Lösung. Diese Zellen werden während 5 bis 20 Prozent der Zeit umgepolt betrieben, das heißt die Kathoden werden in dieser Zeit entmetallisiert.

Der Anstieg der Hilfszellenspannung bei konstantem Entmetallisierstrom ist ein Hinweis auf eine vollständige Entmetallisierung der Kathoden. Dies kann zur Steuerung der Hilfszellen genutzt werden, indem zur Entmetallisierung der Kathoden der Stromfluß zwischen den Anoden und den Kathoden der Hilfszellen umgepolt wird und nach der Entmetallisierung ein Stromfluß mit der ursprünglichen Stromrichtung wieder eingestellt wird, wenn die Spannung zwischen den Anoden und den Kathoden einen vorbestimmten erhöhten Wert erreicht hat. Beim Anstieg der Spannung kann daher sofort wieder auf Normalbetrieb umgeschaltet werden. Wird die Spannung dagegen zeitgesteuert umgepolt, so müssen ausreichende Reservezeiten zur vollständigen Entmetallisierung der Kathoden eingeplant werden. Dies verringert die Kapazität der Hilfszellen. Das sich beim Entmetallisieren an dem Anodenstab abscheidende Metall ist nicht haftfest. Es löst sich im Normalbetrieb infolge der Pulverform schnell wieder auf.

In einer anderen Ausführungsform wird jeweils nur ein Teil der Hilfszellen umgepolt und elektrisch und entmetallisierend betrieben. Der Entmetallisierungsbetrieb wird fortlaufend auf weitere Zellen umgeschaltet. Der zeitliche Abstand der Umschaltung beträgt wenige Minuten bis zu einige Stunden.

Der Hilfszellenstrom und die Zeitdauer der Metallabscheidung in den Hilfszellen werden in allen Fällen so eingestellt, daß sich in der gesamten Galvanisieranlage das erforderliche Gleichgewicht zwischen der Metallauflösung und der Metallabscheidung ergibt, so daß der Gehalt der Metallionen in der Elektrolytflüssigkeit konstant gehalten werden kann. Hierzu muß der Metallgehalt fortlaufend gemessen werden. Weil sich die Konzentration der abzuscheidenden Metallionen in einer Galvanisieranlage nur langsam ändert, ist eine manuelle Analyse im Abstand von einigen Stunden ausreichend. Der Hilfszellenstrom kann daher ohne weiteres analysenabhängig von Hand korrigiert werden.

Dieser Vorgang läßt sich auch automatisieren. In diesem Fall wird die Konzentration des Metalls in der Elektrolytflüssigkeit mit einem Analysator bestimmt und der Stromfluß zwischen den Anoden und den Kathoden der Hilfszellen durch Zuführung eines Istwert-Signals des mit dem Analysator ermittelten Metallionengehaltes zu einer Regeleinrichtung für die Stromversorgung automatisch eingestellt. Damit stellt sich auch die Reduktion der oxidierten Form des Redoxmittels automatisch ein. Der Sollwert des Stromflusses ist von den Prozeßdaten vorgegeben. Der Istwert wird automatisch analysiert. Soll- und lstwert werden in der Regeleinrichtung verglichen. Über diese Stellgröße wird der Hilfszellenstrom geregelt und damit die lonenkonzentration des abzuscheidenden Metalls in der Galvanisieranlage konstant gehalten. Über den Hilfszellenstrom wird primär der Gehalt der lonen des Redoxsystems in der Elektrolytflüssigkeit beeinflußt. Dieser lonengehalt beeinflußt die Auflösungsmenge des auf dem Behandlungsgut abzuscheidenden Metalls.

Die Absenkung des Gehaltes der oxidierten Stoffe des Redoxsystems im Elektrolyten, der von der Galvanisieranlage im Kreislauf in die Hilfszellen, anschließend in den lonengenerator und von dort wieder zurückgeführt wird, hat einen zusätzlichen Nutzeffekt. Das Behandlungsgut in der Galvanisieranlage befindet sich in einer Elektrolytflüssigkeit, die bei Durchführung des erfindungsgemäßen Verfahrens eine verringerte Konzentration der Verbindungen des Redoxsystems in der oxidierten Stufe enthält. Entsprechend weniger Verbindungen des Redoxsystems werden vom Galvanisierstrom an der Behandlungsgutober-fläche reduziert. Die Folge davon ist eine Verbesserung der kathodischen Stromausbeute in der Galvanisieranlage. Der damit verbundene Gewinn an Produktionskapazität beträgt bis zu 10 Prozent.

Ein weiterer Vorteil der Erfindung ist, daß der von Galvanisieranlagen mit löslichen Anoden bekannte Anodenschlamm entfällt. Trotzdem kann teilweise ein "feed and bleed"-Betrieb des Elektrolyten nützlich sein. Dies gilt insbesondere dann, wenn organische und/oder anorganische Zusätze im Elektrolyten langfristig ausgetauscht werden sollen. Als Folge des teilweisen Verwerfens des Elektrolyten wird auch der Metallgehalt anteilsmäßig gesenkt. Um diesen Anteil kann die Kapazität der elektrolytischen Hilfszellen verringert werden. Der lonengehalt des auf dem Behandlungsgut abzuscheidenden Metalls in der Elektrolytflüssigkeit kann somit auch dadurch konstant gehalten werden, daß Verbindungen des Redoxsystems in der oxidierten Form in den Hilfszellen reduziert werden und gleichzeitig ein Teil der Elektrolytflüssigkeit aus dem Galvanisierbehälter entfernt und durch frische Elektrolytflüssigkeit ersetzt wird.

Das erfindungsgemäße Verfahren ist besonders zur Anwendung in horizontalen Durchlaufanlagen, das heißt Galvanisieranlagen, geeignet, in denen plattenförmiges Behandlungsgut, vorzugsweise Leiterplatten, in horizontaler oder vertikaler Lage und horizontaler Richtung linear fortbewegt und dabei mit der Elektrolytflüssigkeit in Kontakt gebracht werden. Das Verfahren kann natürlich auch zur Galvanisierung von Behandlungsgut in herkömmlichen Tauchanlagen eingesetzt werden, in die das Behandlungsgut meist in vertikaler Ausrichtung eingetaucht wird. Gleiches gilt selbstverständlich auch für die Kombination der erfindungsgemäßen Vorrichtung mit entsprechenden Horizontal- oder Tauch-Galvanisieranlagen.

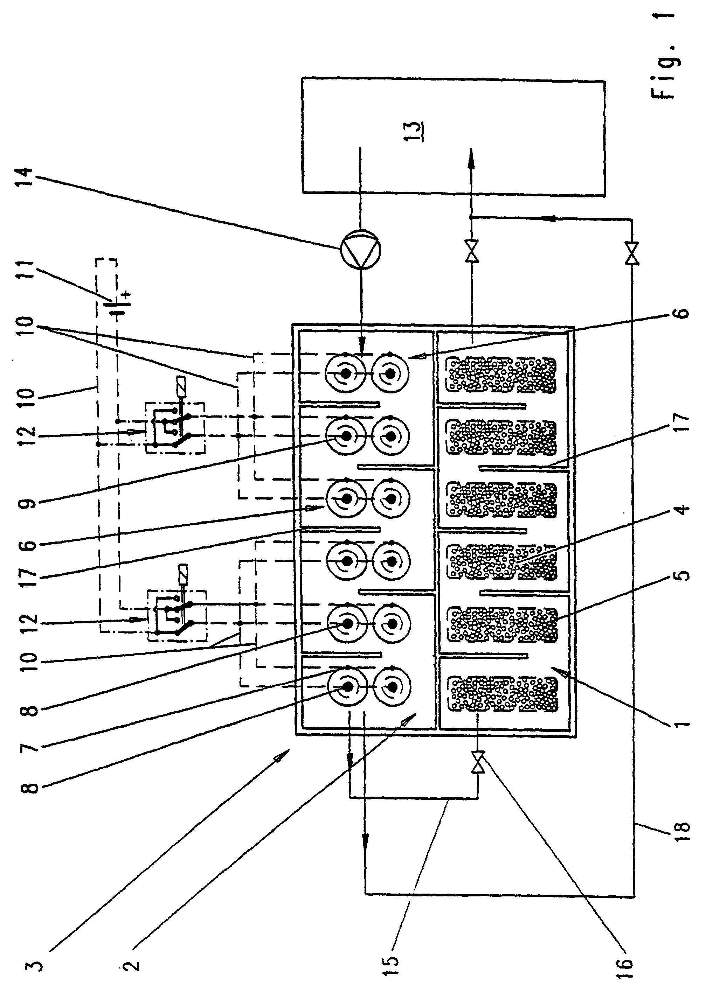

Die Erfindung wird nachfolgend an Hand der Figur 1 näher erläutert. In dieser Figur ist eine Vorrichtung, bestehend aus einem lonengenerator und aus den elektrolytischen Hilfszellen, in der Draufsicht als Beispiel dargestellt.

Der lonengenerator 1 befindet sich zusammen mit dem Hilfszellenbehälter 2 in einem Kombinationsbehälter 3. Im lonengenerator ist das aufzulösende Metall 4 gelagert, das zur Ergänzung der in der Elektrolytflüssigkeit gelösten und durch Metallabscheidung auf dem Behandlungsgut kontinuierlich aus der Flüssigkeit entfernten Metallionen dient. Es befindet sich in Körben 5. Die Körbe können aus Kunststoff oder aus resistentem Metall bestehen, wie zum Beispiel Titan. Das aufzulösende Metall 4, in schüttbarer Form, wird bedarfsweise von oben nachgefüllt. Im Hilfszellenbehälter 2 befinden sich elektrolytische Hilfszellen 6. Sie bestehen aus senkrecht angeordneten, langgestreckten, rohrförmigen Kathoden 7, die zum Beispiel aus Titan-Streckmetall hergestellt sind. Im Zentrum der Kathoden 7 befinden sich ebenfalls langgestreckte stabförmige Anoden 8. Die Anoden 8 bestehen aus Metall, vorzugsweise aus Titan, die an der Oberfläche mit einer resistenten elektrisch leitfähigen Schicht versehen sind. Die elektrolytisch wirksame Oberfläche der Kathoden 7 ist mindestens zehnmal so groß, wie die Oberfläche der Anoden 8. In entsprechender Weise sind die Durchmesser der Kathoden und Anoden gewählt. Die Anoden 8 werden von Diaphragmen 9 umschlossen. Die Diaphragmen bestehen zum Beispiel aus einem gegen den Elektrolyten resistenten Gewebe. Geeignet ist hierfür ein Filz aus Polypropylen. Das Gewebe ist ionendurchlässig. Das an den Anoden 8 entstehende Gas wird dadurch zurückgehalten. Es wird nach oben aus dem Elektrolyten herausgeleitet. Die Hilfszellen 6 sind über gestrichelt dargestellte elektrische Leitungen 10 mit der Hilfszellstromquelle 11 verbunden. Im dargestellten Beispiel sind zwei Gruppen von Hilfszellen gebildet. In jeder Gruppe ist ein Umpolschalter 12 eingefügt. Die Umpolschalter 12 können als elektronische oder elektromechanische Schalter ausgeführt sein. Betätigt werden diese Schalter durch Steuerung von Hand oder durch eine nicht dargestellte Anlagensteuerung. Diese sorgt für die zeitgesteuerte oder potentialgesteuerte Umpolung der Hilfszellengruppen.

Der Elektrolyt in der symbolisch dargestellten Galvanisieranlage 13 wird von einer Pumpe 14 in den Hilfszellenbehälter 2 gefördert. Hier durchströmt er die Hilfszellen 6. Wegen des hohen Gehaltes der Verbindungen des Redoxsystems in der oxidierten Stufe im Elektrolyten, der direkt aus der Galvanisieranlage kommt, wird an den Kathoden der Hilfszellen eine entsprechend große Menge Redoxmittel reduziert und wenig Metall abgeschieden. Über die Rohrleitung 15 und ein Ventil 16 gelangt der Elektrolyt anschließend in den lonengenerator 1.

In diesem wird das aufzulösende Metall vom Elektrolyten durchströmt. Dabei wird es mit den Verbindungen des Redoxsystems und mit dem gelösten Sauerstoff im Elektrolyten in Kontakt gebracht. Beides bewirkt eine Auflösung des im lonengenerator enthaltenen Metalls. Zur Intensivierung des Kontaktes mit dem Metall in den Körben 5 kann der Elektrolyt mäanderförmig um Hindernisse 17 durch den lonengenerator 1 hindurchgeleitet werden.

Vom lonengenerator 1 gelangt der Elektrolyt in die Galvanisieranlage 13 zurück. Der Abstand des Kombinationsbehälters 3 von der Galvanisieranlage 13 soll möglichst klein sein.

In der Figur ist auch eine zusätzliche Verrohrung 18 mit einem weiteren Ventil dargestellt. Diese Verrohrung mit einer entsprechenden Schaltung der Ventile erlaubt die zeitweilige Umgehung des lonengenerators, zum Beispiel im Falle von Wartungsarbeiten. Andere Verrohrungen und Anordnungen der Behälter sind möglich. Sie sind jedoch nicht erfindungswesentlich. So kann auch der Elektrolyt von der Galvanisieranlage 13 zuerst in den lonengenerator 1 und von dort erst in den Hilfszellenbehälter 2 gefördert werden. In diesem Falle ist die Metallauflösung wegen einer größeren Konzentration der Verbindungen des Redoxsystems in der oxidierten Stufe intensiver. Der lonengenerator kann daher räumlich kleiner aufgebaut sein. Allerdings verringert sich bei dieser Elektrolytführung der Wirkungsgrad der Hilfszellen.

In einer weiteren Ausführungsform der Erfindung werden der lonengenerator 1 und/oder die Hilfszellen 6 in die Galvanisieranlage 13 integriert. Der Aufwand für den Kombinationsbehälter 3 entfällt in diesem Falle.

### Bezugszeichenliste

- 1: lonengenerator
- 2: Hilfszellenbehälter
- 3: Kombinationsbehälter
- 4: aufzulösendes Metall
- 5: Körbe
- 6: Hilfszelle
- 7: Kathode
- 8: Anode
- 9: Diaphragma
- 10: elektrische Leitung
- 11: Hilfszellstromquelle
- 12: Umpolschalter
- 13: Galvanisieranlage
- 14: Pumpe
- 15: Rohrleitung
- 16: Ventil
- 17: Hindernis
- 18: Verrohrung

## Patentansprüche

1. Verfahren zur Regulierung der Konzentration von Metallionen in einer zur Abscheidung von Metall dienenden Elektrolytflüssigkeit, die zusätzlich Verbindungen eines elektrochemisch reversiblen Redoxsystems enthält, mit deren oxidierter Form Metall in einem von der Elektrolytflüssigkeit durchströmten lonengenerator aufgelöst wird, so daß die Verbindungen in der oxidierten Form dabei reduziert werden, wobei ferner die dabei entstehenden Verbindungen in der reduzierten Form an unlöslichen Anoden wieder oxidiert werden und das Metall aus der Elektrolytflüssigkeit, die sich in mindestens einem Galvanisierbehälter einer Galvanisieranlage befindet, unter Verwendung der unlöslichen Anoden auf Behandlungsgut abgeschieden wird,
**dadurch gekennzeichnet, daß**
a. zumindest ein Teil der in der Galvanisieranlage (13) enthaltenen Elektrolytflüssigkeit durch eine oder mehrere mindestens eine unlösliche Anode (8) und mindestens eine Kathode (7) aufweisende elektrolytische Hilfszellen (6) geleitet wird, und
b. zwischen den Anoden (8) und den Kathoden (7) der Hilfszellen (6) ein so hoher elektrischer Stromfluß eingestellt wird, daß die Stromdichte an der Anodenoberfläche mindestens 6 A/dm² und die Stromdichte an der Kathodenoberfläche höchstens 3 A/dm² beträgt.

2. Verfahren nach Anspruch 1, **dadurch gekennzeichnet, daß** die Hilfszellen (6) getrennt vom Galvanisierbehälter angeordnet werden und daß die Elektrolytflüssigkeit im Kreislauf durch die Galvanisierbehälter und die Hilfszellen (6) gefördert wird.

3. Verfahren nach einem der vorstehenden Ansprüche, **dadurch gekennzeichnet, daß** der elektrische Stromfluß zwischen den Anoden (8) und den Kathoden (7) der Hilfszellen (6) zeitweilig umgepolt wird.

4. Verfahren nach einem der vorstehenden Ansprüche, **dadurch gekennzeichnet, daß** die Hilfszellen (6) in elektrisch separat geschaltete Gruppen aufgeteilt werden und der elektrische Stromfluß zwischen den Anoden (8) und den Kathoden (7) der Hilfszellen (6) in den einzelnen Gruppen nacheinander umgepolt wird.

5. Verfahren nach einem der vorstehenden Ansprüche, **dadurch gekennzeichnet, daß** der elektrische Stromfluß in den Hilfszellen (6) so eingestellt wird, daß der Gehalt der Metallionen in der Elektrolytflüssigkeit konstant gehalten wird.

6. Verfahren nach einem der vorstehenden Ansprüche, **dadurch gekennzeichnet, daß** der elektrische Stromfluß zwischen den Anoden (8) und den Kathoden (7) der Hilfszellen (6) zur Entmetallisierung der Kathoden (7) umgepolt wird und der elektrische Stromfluß mit der ursprünglichen Stromrichtung dann wieder eingestellt wird, wenn die Spannung zwischen den Anoden (8) und den Kathoden (7) der Hilfszellen (6) einen vorbestimmten Wert erreicht hat.

7. Verfahren nach einem der Ansprüche 1 und 2, **dadurch gekennzeichnet, daß** die Kathoden (7) der Hilfszellen (6) in der Elektrolytflüssigkeit stromlos entmetallisiert werden.

8. Verfahren nach einem der vorstehenden Ansprüche, **dadurch gekennzeichnet, daß** der Gehalt der Metallionen in der Elektrolytflüssigkeit konstant gehalten wird, indem die Verbindungen des Redoxsystems in der oxidierten Form in den Hilfszellen (6) reduziert wird und gleichzeitig ein Teil der Elektrolytflüssigkeit aus dem Galvanisierbehälter entfernt und durch frische Elektrolytflüssigkeit ersetzt wird.

9. Vorrichtung zur Regulierung der Konzentration von Metallionen in einer zur Abscheidung von Metall dienenden Elektrolytflüssigkeit auf Behandlungsgut in mindestens einem Galvanisierbehälter einer Galvanisieranlage, wobei die Galvanisieranlage unlösliche Anoden und eine mit den Anoden und dem Behandlungsgut elektrisch verbundene Stromversorgung aufweist,
**gekennzeichnet durch**
a. mindestens eine elektrolytische Hilfszelle (6), jeweils bestehend aus
i. mindestens einer Kathode (7),
ii. mindestens einer unlöslichen Anode (8),
iii. wobei das Verhältnis der Oberfläche der Anoden (8) zur Oberfläche der Kathoden (7) mindestens 1 : 4 beträgt, und
iv. einer Stromversorgung (11) für die Hilfszellen (6), die mit den Anoden (8) und den Kathoden (7) der Hilfszellen (6) elektrisch verbunden ist, sowie
b. Mittel (14;15;16), mit denen ein Flüssigkeitskreislauf der Elektrolytflüssigkeit zwischen den Hilfszellen (6) und der Galvanisieranlage (13) erzeugbar ist.

10. Vorrichtung nach Anspruch 9, **dadurch gekennzeichnet, daß** die unlöslichen Anoden (8) der Hilfszellen (6) mit einer Beschichtung versehen sind, die im wesentlichen aus Edelmetall und/oder einer Metallmischoxidbeschichtung besteht.

11. Vorrichtung nach einem der Ansprüche 9 und 10, **dadurch gekennzeichnet, daß** die Kathoden (7) der Hilfszellen (6) rohrförmig ausgebildet sind und aus Streckmetall bestehen.

12. Vorrichtung nach einem der Ansprüche 9 bis 11, **dadurch gekennzeichnet, daß** nach oben offene und aus einem Gewebe bestehende Diaphragmen (9) zwischen den Anoden (8) und den Kathoden (7) der Hilfszellen (6) angeordnet sind.

13. Vorrichtung nach einem der Ansprüche 9 bis 12, **dadurch gekennzeichnet, daß** die Hilfszellen (6), ein lonengenerator (1), der zur Bildung von Metallionen in der Elektrolytflüssigkeit durch Auflösung von Metall mit Hilfe von Verbindungen eines reversiblen Redoxsystems dient, und/oder Elektrolytfiltereinrichtungen in einem Behälter gemeinsam angeordnet sind und daß Einrichtungen (14) zur Förderung der Elektrolytflüssigkeit aus dem Galvanisierbehälter durch die gemeinsame Anordnung (3) vorgesehen sind.

14. Vorrichtung nach einem der Ansprüche 9 bis 13, **dadurch gekennzeichnet, daß** zur Umpolung des Stromflusses zwischen den Anoden (8) und den Kathoden (7) der Hilfszellen (6) elektrische Schalter und/oder Umpolschalter (12) in den elektrischen Verbindungsleitungen (10) zwischen der Stromversorgung (11) für die Hilfszellen (6) und den Hilfszellen (6) vorgesehen sind.

15. Vorrichtung nach einem der Ansprüche 9 bis 14, **dadurch gekennzeichnet, daß** ein Analysator zur Bestimmung des Metallionengehaltes in der Elektrolytflüssigkeit vorgesehen ist.

16. Vorrichtung nach Anspruch 15, **dadurch gekennzeichnet, daß** zur Regelung des Stromflusses zwischen den Anoden (8) und den Kathoden (7) der Hilfszellen (6) eine Zuführung eines lstwert-Signals des mit dem Analysator ermittelten Metallionengehaltes zu einer Regeleinrichtung für die Stromversorgung vorgesehen ist.

## Claims

1. Method of regulating the concentration of metal ions in an electrolytic fluid, which is used for the deposition of metal and additionally contains compounds of an electrochemically reversible redox system, metal being dissolved with the oxidised form of said compounds in an ion generator, traversed by the electrolytic fluid, so that the compounds in the oxidised form are thereby reduced, the resultant compounds in the reduced form also being oxidised again on insoluble anodes, and the metal from the electrolytic fluid, which is situated in at least one electroplating container of an electroplating system, being deposited on an item to be treated by using the insoluble anodes,
**characterised in that**
a. at least a portion of the electrolytic fluid, contained in the electroplating system (13), is conducted through one or a plurality of electrolytic auxiliary cells (6), which have at least one insoluble anode (8) and at least one cathode (7), and
b. such a high electric current flow is set between the anodes (8) and the cathodes (7) of the auxiliary cells (6) that the current density on the anode surface is at least 6 A/dm², and the current density on the cathode surface is at most 3 A/dm².

2. Method according to claim 1, **characterised in that** the auxiliary cells (6) are disposed separately from the electroplating container, and **in that** the electrolytic fluid is circulated through the electroplating containers and the auxiliary cells (6).

3. Method according to one of the preceding claims, **characterised in that** the poles of the electric current flowing between the anodes (8) and the cathodes (7) of the auxiliary cells (6) are temporarily reversed.

4. Method according to one of the preceding claims, **characterised in that** the auxiliary cells (6) are divided into separately electrically connected groups, and the poles of the electric current flowing between the anodes (8) and the cathodes (7) of the auxiliary cells (6) are reversed in succession in the individual groups.

5. Method according to one of the preceding claims, **characterised in that** the electric current flowing in the auxiliary cells (6) is so set that the content of the metal ions in the electrolytic fluid is kept constant.

6. Method according to one of the preceding claims, **characterised in that** the poles of the electric current flowing between the anodes (8) and the cathodes (7) of the auxiliary cells (6) are reversed for deplating the cathodes (7), and the electric current flow is then set again with the original current direction when the voltage between the anodes (8) and the cathodes (7) of the auxiliary cells (6) has reached a predetermined value.

7. Method according to one of claims 1 and 2, **characterised in that** the cathodes (7) of the auxiliary cells (6) are deplated in the electrolytic fluid electrolessly.

8. Method according to one of the preceding claims, **characterised in that** the content of the metal ions in the electrolytic fluid is kept constant by reducing the compounds of the redox system in the oxidised form in the auxiliary cells (6) and by simultaneously removing a portion of the electrolytic fluid from the electroplating container and replacing such by fresh electrolytic fluid.

9. Apparatus for regulating the concentration of metal ions in an electrolytic fluid, which is used for the deposition of metal, on an item to be treated in at least one electroplating container of an electroplating system, the electroplating system including insoluble anodes and a power supply, which is electrically connected to the anodes and the item to be treated,
**characterised by**
a. at least one electrolytic auxiliary cell (6), each comprising
i. at least one cathode (7),
ii. at least one insoluble anode (8),
iii. the ratio between the surface of the anodes (8) and the surface of the cathodes (7) being at least 1 : 4, and
iv. a power supply (11) for the auxiliary cells (6), which is electrically connected to the anodes (8) and the cathodes (7) of the auxiliary cells (6), as well as
b. means (14;15;16), whereby a circulation of the electrolytic fluid can be produced between the auxiliary cells (6) and the electroplating system (13).

10. Apparatus according to claim 9, **characterised in that** the insoluble anodes (8) of the auxiliary cells (6) are provided with a coating which is substantially formed from noble metal and/or a mixed metal oxide coating.

11. Apparatus according to one of claims 9 and 10, **characterised in that** the cathodes (7) of the auxiliary cells (6) have a tubular configuration and are formed from expanded metal.

12. Apparatus according to one of claims 9 to 11, **characterised in that** diaphragms (9), which are upwardly open and formed from a fabric, are disposed between the anodes (8) and the cathodes (7) of the auxiliary cells (6).

13. Apparatus according to one of claims 9 to 12, **characterised in that** the auxiliary cells (6), an ion generator (1) which serves to form metal ions in the electrolytic fluid by dissolving metal by means of compounds of a reversible redox system, and/or electrolyte filter arrangements are jointly disposed in one container, and **in that** means (14) are provided for conveying the electrolytic fluid from the electroplating container through the joint arrangement (3).

14. Apparatus according to one of claims 9 to 13, **characterised in that**, to reverse the poles of the current flowing between the anodes (8) and the cathodes (7) of the auxiliary cells (6), electric switches and/or pole reversal switches (12) are provided in the electric connecting leads (10) between the power supply (11) for the auxiliary cells (6) and the auxiliary cells (6).

15. Apparatus according to one of claims 9 to 14, **characterised in that** an analyser is provided for determining the metal ion content in the electrolytic fluid.

16. Apparatus according to claim 15, **characterised in that**, to regulate the current flowing between the anodes (8) and the cathodes (7) of the auxiliary cells (6), a means is provided for supplying an actual value signal of the metal ion content, determined with the analyser, to a regulator for the power supply.

## Revendications

1. Procédé destiné à réguler la concentration des ions métalliques dans un électrolyte utilisé pour un dépôt de métal, qui contient en plus des composés d'un système redox électrochimique réversible, dont la forme oxydée permet de décomposer le métal dans un générateur d'ions à travers lequel est acheminé l'électrolyte, de telle sorte que les composés sont réduits, dans la forme oxydée, les composés formés dans la forme réduite à cet effet étant en outre à nouveau oxydés sur les anodes insolubles, et le métal, à partir de l'électrolyte, qui est contenu dans au moins une cuve électrolytique d'une installation galvanoplastique, est déposé sur l'objet à traiter par l'utilisation des anodes insolubles, **caractérisé en ce que**
a) au moins une partie de l'électrolyte contenu dans l'installation galvanoplastique (13) est acheminée à travers une ou plusieurs cellules électrolytiques auxiliaires (6) comportant au moins une anode (8) insoluble et au moins une cathode (7), et
b) un flux de courant électrique est régulé entre les anodes (8) et les cathodes (7) des cellules auxiliaires (6) à une valeur si élevée que la densité de courant sur la surface des anodes est au moins égale à 6 A/dm² et la densité de courant sur la surface des cathodes est au maximum égale à 3 A/dm².

2. Procédé selon la revendication 1, **caractérisé en ce que** les cellules auxiliaires (6) sont séparées de la cuve électrolytique et **en ce que** l'électrolyte est acheminé en circuit à travers les cuves électrolytiques et les cellules auxiliaires (6).

3. Procédé selon l'une des revendications précédentes, **caractérisé en ce que** le flux de courant électrique entre les anodes (8) et les cathodes (7) des cellules auxiliaires (6) est temporairement inversé.

4. Procédé selon l'une des revendications précédentes, **caractérisé en ce que** les cellules auxiliaires (6) sont divisées en groupes à alimentation électrique séparée et le flux de courant électrique entre les anodes (8) et les cathodes (7) des cellules auxiliaires (6) est inversé successivement dans les différents groupes.

5. Procédé selon l'une des revendications précédentes, **caractérisé en ce que** le flux de courant électrique dans les cellules auxiliaires (6) est réglé de manière telle que la teneur des ions métalliques est maintenue constante dans l'électrolyte.

6. Procédé selon l'une des revendications précédentes, **caractérisé en ce que** le flux de courant électrique entre les anodes (8) et les cathodes (7) des cellules auxiliaires (6) est inversé pour la démétallisation des cathodes (7) et le flux de courant électrique est à nouveau réglé ensuite dans le sens de courant initial, lorsque la tension entre les anodes (8) et les cathodes (7) des cellules auxiliaires (6) a atteint une valeur prédéfinie.

7. Procédé selon les revendications 1 et 2, **caractérisé en ce que** les cathodes (7) des cellules auxiliaires (6) sont démétallisées par voie sans courant dans l'électrolyte.

8. Procédé selon l'une des revendications précédentes, **caractérisé en ce que** la teneur en ions métalliques dans l'électrolyte est maintenue constante, du fait que les composés du système redox dans la forme oxydée sont réduits dans les cellules auxiliaires (6) et en même temps une partie de l'électrolyte est retirée hors de la cuve électrolytique et remplacée par un électrolyte frais.

9. Dispositif destiné à réguler la concentration des ions métalliques dans un électrolyte utilisé pour déposer du métal sur l'objet à traiter dans au moins une cuve électrolytique d'une installation de galvanoplastie, l'installation de galvanoplastie comportant des anodes insolubles et une alimentation en courant reliée électriquement avec les anodes et l'objet à traiter, **caractérisé par**
a) au moins une cellule électrolytique auxiliaire (6), qui comporte chacune
i. au moins une cathode (7),
ii. au moins une anode insoluble (8),
iii. le rapport entre la surface des anodes (8) et la surface des cathodes (7) étant au moins égal à 1:4, et
iv. une alimentation en courant (11) pour les cellules auxiliaires (6), qui est reliée électriquement avec les anodes (8) et les cathodes (7) des cellules auxiliaires (6), ainsi que
b) des moyens (14 ; 15 ; 16), qui permettent de créer un circuit de circulation de l'électrolyte entre les cellules auxiliaires (6) et l'installation de galvanoplastie (13).

10. Dispositif selon la revendication 9, **caractérisé en ce que** les anodes insolubles (8) des cellules auxiliaires (6) sont munies d'un revêtement, qui est formé sensiblement par un métal précieux et/ou un revêtement d'oxydes mixtes métalliques.

11. Dispositif selon les revendications 9 et 10, **caractérisé en ce que** les cathodes (7) des cellules auxiliaires (6) sont conçues en forme de tube et sont réalisées en métal étiré.

12. Dispositif selon l'une quelconque des revendications 9 à 11, **caractérisé en ce que** des diaphragmes (9), ouverts vers le haut et réalisés dans un tissu, sont disposés entre les anodes (8) et les cathodes (7) des cellules auxiliaires (6).

13. Dispositif selon l'une quelconque des revendications 9 à 12, **caractérisé en ce que** les cellules auxiliaires (6), un générateur d'ions (1), qui est destiné à former les ions métalliques dans l'électrolyte par la décomposition du métal à l'aide des composés d'un système redox réversible, et/ou des unités de filtrage de l'électrolyte sont disposés ensemble dans une cuve et **en ce que** les unités (14) sont prévues pour acheminer l'électrolyte à partir de la cuve électrolytique à travers le dispositif commun (3).

14. Dispositif selon l'une quelconque des revendications 9 à 13, **caractérisé en ce que** pour l'inversion du flux de courant entre les anodes (8) et les cathodes (7) des cellules auxiliaires (6), il est prévu des commutateurs électriques et/ou des inverseurs de polarité (12) dans les lignes électriques (10) établissant la liaison entre l'alimentation de courant (11) pour les cellules auxiliaires (6) et les cellules auxiliaires (6).

15. Dispositif selon l'une quelconque des revendications 9 à 14, **caractérisé en ce qu'**il est prévu un analyseur destiné à déterminer la teneur en ions métalliques de l'électrolyte.

16. Dispositif selon la revendication 15, **caractérisé en ce que** pour réguler le flux entre les anodes (8) et les cathodes (7) des cellules auxiliaires (6), il est prévu la transmission d'un signal contenant la valeur effective de la teneur en ions métalliques, déterminée par l'analyseur, vers une unité de réglage destinée à l'alimentation de courant.
